(19) **Europäisches Patentamt / European Patent Office / Office européen des brevets**

(11) **EP 0 827 360 B1**

(12) **EUROPEAN PATENT SPECIFICATION**

(45) Date of publication and mention
of the grant of the patent:
**30.09.2009 Bulletin 2009/40**

(51) Int Cl.:
*H04R 1/40* (2006.01)          *H04R 1/38* (2006.01)
*H04M 1/19* (2006.01)

(21) Application number: **97306615.2**

(22) Date of filing: **29.08.1997**

(54) **A handset and a connector therefor**

Tragbares Handgerät und entsprechender Verbinder

Combiné portatif et connecteur correspondant

(84) Designated Contracting States:
**AT BE CH DE DK ES FI FR GB GR IE IT LI LU MC NL PT SE**

(30) Priority: **30.08.1996 GB 9618224**
**24.12.1996 GB 9626918**

(43) Date of publication of application:
**04.03.1998 Bulletin 1998/10**

(73) Proprietor: **Nokia Corporation**
**02150 Espoo (FI)**

(72) Inventors:
• **Elliott, Stephen**
**Winchester (GB)**

• **Rex, James**
**Romsey (GB)**

(74) Representative: **Khan, Mohammed Saiful Azam**
**Potter Clarkson LLP**
**Park View House**
**58 The Ropewalk**
**Nottingham**
**NG1 5DD (GB)**

(56) References cited:
**EP-A- 0 663 749          EP-A- 0 711 095**
**GB-A- 2 218 303          US-A- 4 742 548**
**US-A- 5 303 307**

EP 0 827 360 B1

**Description**

The present invention relates to a handset and a connector therefor. In particular, it relates to the microphone arrangement on the handset.

A handset may be a radio telephone, a camcorder, a dictation machine and the like.

Pressure microphones have been used in handsets, such as radiotelephones. A pressure microphone generates an electrical signal which is proportional to the fluctuating component of the pressure at its port. The port is typically provided by a hole in the front cover of the radio telephone. Alternatively, it is provided in the front of a flip element or boom arm of the radiotelephone.

The sensitivity of a pressure microphone to a point source is independent of the distance or direction of that source. Hence, its speech and noise sensitivities are equal: there is no discrimination against noise sources.

Noise cancelling microphones have also been used in handsets, such as radiotelephones. This type of microphone generally operates by responding to a pressure differential produced by sound waves being received at different positions on it. There are typically two different positions on the microphone, namely its the front and back surfaces. The sound waves reach these positions via two separate ports. Near-field sounds such as a user's voice create a significantly greater pressure differential than far-field sounds such as background noise. In this way the near-field sound is detected by the noise cancelling microphone in preference to the far-field noise. The two ports are generally provided by a hole in the front and a hole in the back of a flip element on the radio telephone.

A noise cancelling microphone having ports on the front and back surfaces does not effectively cancel far field noise. This is due to, amongst other things, diffraction of acoustic waves by the handset. Also, the ports are separated by the width of the handset, which further results in poor noise discrimination.

Moreover, handsets having noise cancelling microphones in a flip element or boom arm to improve noise discrimination are expensive and add to the size and complexity of the handset. They are also susceptible to damage, resulting in an overall less reliable handset.

US 5 303 307 describes an adjustable filter for pressure differential microphones for use in telephony/communications systems.

An improved Signal to Noise Ratio is achieved on the axis defined by the two microphone ports.

According to one aspect of the present invention, there is provided a handset comprising first and second microphone ports opening onto a single surface of the handset and located such that the openings of the ports and the expected location of the sound source relative to the handset are substantially aligned according to claim 1.

An advantage of such a handset is that the noise discrimination is improved. Reasons for this include the following. Provision of the microphone ports on a single surface can minimise the diffraction effects of the handset. Additionally, the port openings and the expected location of the sound source are aligned, to utilise the fact that a noise cancelling microphone is generally more sensitive to speech along its axis (i.e. the axis along which the port openings lie), than noise along that axis, and also, that it is more sensitive to speech along that axis that to noise off that axis.

The ports may open onto the base of a handset. However, this will depend on the handset in question. For example, they may open onto the front surface of a radio telephone which is curved to fit the shape of a user's head.

Preferably, the openings of the ports are close together. Bringing the ports close together improves the noise discrimination of the microphone.

Also, it is desirable for the opening of the expected location of the sound source to be near the closest microphone port, so as to optimise the signal to noise ratio.

The noise cancelling microphone may be one of a number of alternatives. For example, it may be a first order microphone or a second order microphone.

The first order microphone might be a pressure gradient microphone. Such a microphone has bi-directional directivity, and therefore improves discrimination against off-axis noise as compared with on-axis noise. Alternatively, it might be a differential array of pressure microphones. Such an array determines the pressures at the port of each pressure microphone and sums them electrically. This alternative has the advantage that the noise discrimination can be adjusted by adjusting the gain of the pressure microphones.

The second order microphone might be a pressure gradient gradient microphone. Such a microphone further improves the discrimination of the microphone against off-axis noise as compared with on-axis noise. Alternatively, it might be differential array, including three pressure microphones or a pressure gradient microphone and a pressure microphone.

There may be provided a connector for a handset, the connector comprising first and second microphone ports opening at a first surface of the connector and located such that the openings of the ports and the expected location of the sound source relative to the connector are substantially aligned.

As well as the advantages provided by the first aspect of the invention, the connector provides the additional advantage that no unsightly holes are required in the covers of the handset or the flip element or boom arm in order to provide the benefits of the noise cancelling microphone. The connector in accordance with the present invention also ensures a reliable and accurate positioning of the microphone ports close to the microphone.

Preferably, the connector comprises a recess for receiving a microphone. Locating the microphone in the connector in such a manner may also provide the advantage that space is saved in the radio telephone which is an important consideration in the mobile telephone industry. However, the invention is not limited to the microphone being received within the connector. The microphone may also be received on formations projecting from the top of the connector or in any other configuration on the connector. Ideally the microphone is received by push fitting into the recess provided on the connector.

The connector may comprise a conductive track disposed so as to contact an output terminal of the microphone for coupling the microphone to the circuit board of the handset. Consequently, such coupling is achieved by simply placing the microphone onto the relevant track of the connector. The placement of the microphone may be provided manually or by an automated placement machine. Either way, the placement of the microphone in the connector, ideally a system connector, saves assembly time and is simpler and more reliable than the prior art method of spot soldering the microphone directly onto the circuit board. The connector may be reflow soldered to the circuit board early on in the assembly of the handset. During the same reflow solder process the conductive tracks for coupling the microphone to the circuit board may also be made to the circuit board thus saving assembly time. In prior art radio telephones, for example, this would have been troublesome as the microphone attached to the wires would be damaged by the heat from the reflow soldering process.

Another advantage of this type of connector is that after placing the microphone onto a contact portion of the relevant conductive track, the connector may also allow the microphone to be removed by simply lifting it away from the contact portion. In this way a microphone which is faulty may be replaced without having to de-solder any connections to the circuit board thus saving time and effort and reducing the risk of damage to other components on the circuit board.

Preferably the conductive track for coupling the microphone to the circuit board is provided with a spring contact. The springs contacts ensures that a reliable connection is made between the microphone and the microphone tracks of the connector.

Suitably the conductive tracks of the connector and the output terminals of the microphone are made of metal.

Ideally the microphone is provided with output terminals in the form of two concentric contacts. These contacts allow the microphone to be placed on the contacts of the connector without having to rotate the microphone into a correct orientation.

The microphone may be located in a sound insulating elastomeric boot before being placed in the connector. The elastomeric boot provides for a comfortable push fit of the microphone in the connector. The elastomeric boot also ensures that the microphone is sound insulated thus allowing it to operate more effectively.

Embodiments of the present invention will now be described, by way of example, with reference to the accompanying drawings, of which:

Figure 1 illustrates a generalised microphone;
Figure 2 illustrates examples of microphones and their equivalent acoustic circuits;
Figure 2a illustrates a single port microphone and its equivalent circuit;
Figure 2b illustrates a two port microphone and its equivalent circuit;
Figure 2c illustrates a three port microphone and its equivalent circuit;
Figure 3 illustrates a comparison between measured and approximated speech sound pressure levels against distance in front of a user's lips;
Figure 4 illustrates the geometry of two port openings and a point sound source;
Figure 5 illustrates on-axis sensitivity against frequency held at different distances from a user's lips for a pressure gradient microphone;
Figure 6 illustrates on-axis sensitivity against frequency held at different distances from a user's lips for a cardioid microphone;
Figure 7 illustrates on-axis noise discrimination of a pressure gradient microphone held at different distances from a user's lips;
Figure 8 illustrates on-axis noise discrimination of pressure gradient microphones having different distances between their port openings;
Figure 9 illustrates far-field directivities of four first order microphones;
Figure 10 illustrates diffuse-field directivity factors of first order microphones;
Figure 11 illustrates on-axis sensitivity against frequency held at different distances from a user's lips for a pressure gradient gradient microphone;
Figure 12 illustrates on-axis noise discrimination of a pressure gradient gradient microphone held at different distances from a user's lips;
Figure 13 illustrates far-field directivities of a PGG microphone;
Figure 14 illustrates a basic structure of a handset of an embodiment of the present invention;

Figure 15 illustrates a radiotelephone having a connector;

Figure 16 illustrates an exploded perspective view of a connector according to an embodiment of the present invention;

Figure 17 is a side cross sectional view of the connector of figure 16;

Figure 18 illustrates a typical far field directivity in the base plane of a first-order microphone handset according to the present invention; and

Figure 19 illustrates a typical far field directivity in the plane of symmetry of a first-order microphone handset according to the present invention.

The noise discrimination effected by a handset of the present invention, can be exemplified using microphone and speech and background noise models. These are outlined below.

**Microphone models**

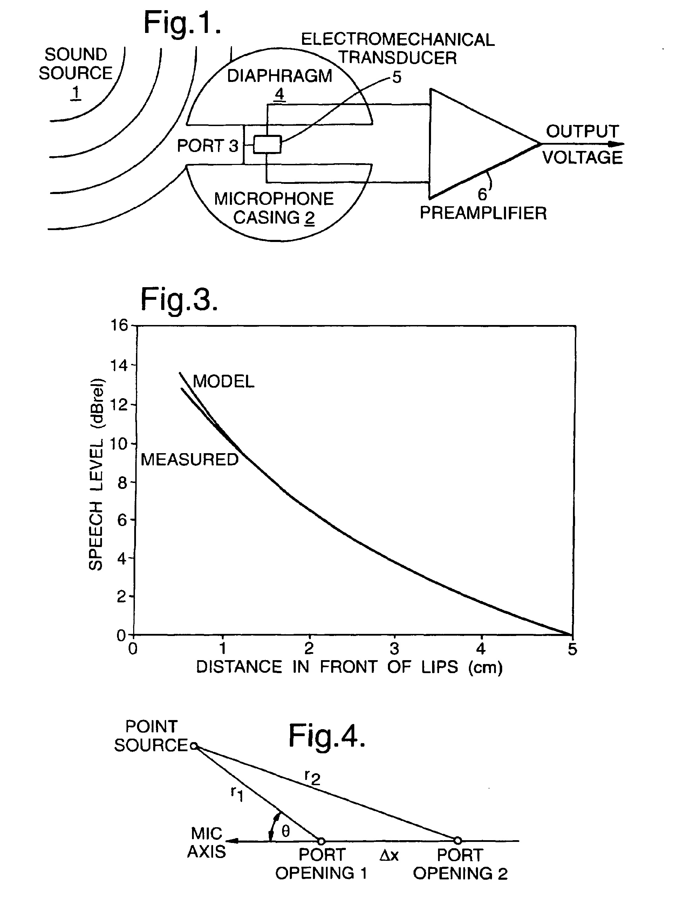

Figure 1 illustrates a generalised microphone. The generalised microphone comprises a microphone casing 2, a port or ports 3, a diaphragm 4, an electromechanical transducer 5, and a preamplifier 6.

Sound waves, radiated by a sound source 1, arrive at the microphone casing 2, and produce sound pressures at the openings of the one or more ports 3. These pressures are conducted through the port or ports 3 to the diaphragm 4, causing a varying pressure difference across it. The diaphragm 4 moves in response to this pressure difference, and this motion is transmitted to the electromechanical transducer element 5, which converts the motion into a corresponding electrical signal. Finally, this signal is amplified by the preamplifier 6, and possibly filtered, to give an output voltage.

The sensitivity of this microphone to the source 1 is defined as:

$$S = v/p_1 \qquad\qquad \textit{Microphone Sensitivity}$$

where v is the microphone's output voltage, and $p_1$ is the sound pressure produced at the opening of the first port by the source 1. To find an expression for the microphone's sensitivity in terms of parameters which can be varied, a mathematical model needs to be considered.

Any microphone generalised by Figure 1 can be modelled in three parts. The first part is the sound-field submodel, which describes the relationship between the parameters of the sound source and the resulting pressures at the openings of the ports. The second part is the porting submodel, which relates the port-opening sound pressures to the resultant pressure difference across the diaphragm. The third is the electromechanical submodel, which calculates the microphone output voltage as a function of the diaphragm pressure difference.

Since microphones are linear devices, they can be analysed in the frequency domain, and all time-dependent variables can be represented by their frequency-dependent complex amplitudes. For example, the real microphone output voltage at radian frequency $\omega$ is given by $\mathrm{Re}[v(\omega)e^{j\omega t}]$.

**The Sound-Field Submodel**

The sound-field submodel calculates the sound pressures, $p_1$, $p_2$, ..., $p_N$, produced at the openings of the microphone's N ports by the sound source 1. The sound field of a real source will often be highly complicated, depending on its radiation characteristics, and on reflection and diffraction around nearby objects. However, any sound field can be considered as the summation of a number of spherical sound waves, radiated by point (infinitesimally small) monopole sources in a free field (no objects present). Hence, the sound-field submodel simply calculates the port-opening sound pressures produced by a single point monopole source.

The port-opening sound pressures are determined not only by the nature of the incident sound field, and their positions in it, but also by the shape of the microphone's casing, which diffracts the incident sound. However, for simplicity the sound-field model ignores diffraction effects of the microphone casing. This is because it can be generalised that sound pressures are usually increased on the side from which the sound arrives, and decreased on the opposite. Further, whilst diffraction effects reduce the performance of a microphone, the effects are not, on the whole, that significant for handsets. This is because diffraction effects depend on the frequencies of the sound and the size of the handset casing. That is, an object only significantly alters the sound field around it, by diffraction, only at wavelengths which are comparable with, or smaller than, the dimensions of the object. Thus, diffraction will only be significant at the higher frequencies of interest for a radio telephone, for example. In this case, the speech band of 300 Hz to 3.4 kHz, is of consideration. This corresponds to wavelengths between about 113 cm and 10 cm. Hence, a normal-sized radio telephone casing will have significant diffraction effects only at the higher frequencies of interest.

Hence, the sound-field submodel assumes that the sound pressures at the port openings are the same as the pressures which would exist at those positions in a free field, which no microphone present. If the distance of the nth port opening from the point monopole source is $r_n$, the sound pressure there is:

$$p_n = A e^{-jkr_n} / r_n \qquad \textit{Sound-Field Submodel} \quad (1)$$

Here A is the complex source amplitude and k = ω/c is the sound wavenumber, where c is the speed of sound.

**Porting Submodels**

A microphone's porting submodel calculates the pressure difference across its diaphragm, $p_D$, which results when the port-mouth sound pressures $p_1$, $p_2$, ..., $p_N$ are transmitted through the N ports to either side of the diaphragm. Clearly, $p_D$ equals the sum of the pressures transmitted to the front of the diaphragm, minus the sum of the pressures transmitted to the back. Let the pressure transmitted by the nth port be $\alpha_n p_n$, where $\alpha_n$ is the "pressure transfer function" of this port. Then:

$$pD = \sum_{n-1}^{N} \pm \alpha_n p_n \; .$$

where $\alpha_n$ is preceded by a plus sign if the nth port leads to the front of the diaphragm, and a minus sign if it leads to the back.

The pressure transfer functions of the ports depend on (i) their internal geometry, and (ii) the acoustic impedance of any objects inside them, including the diaphragm. In a handset microphone, the port dimensions will be much smaller than any wavelength of interest, so the ports can be analysed as systems of lumped acoustic elements. Each element has a particular acoustic impedance, and these impedances can be assembled into an equivalent circuit, in which sound pressure is analogous to voltage in an electrical circuit, and volume velocity (i.e volume flow rate, in $m^3 s^{-1}$) is analogous to current.

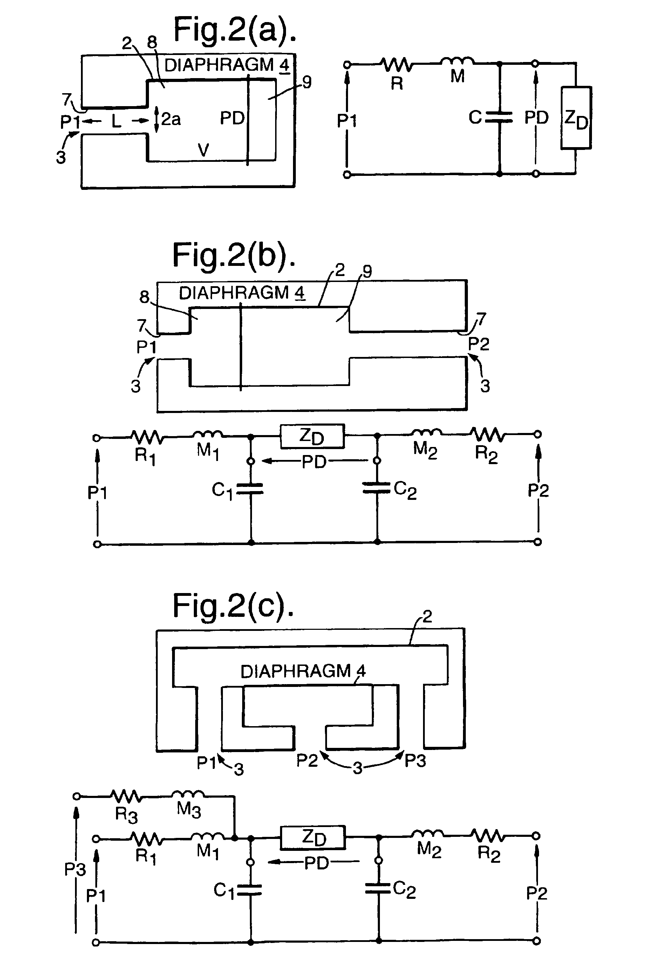

Figure 2 illustrates simple forms of one, two and three port microphones, together with their equivalent acoustic circuits (reference numerals in Figure 2 correspond to those in Figure 1). The pressure transfer functions for these microphones are derived below.

**A Single Port**

Figure 2a illustrates a single-port microphone and its equivalent circuit.

The porting submodel of this microphone is:

$$pD = \alpha_1 p_1 \qquad \textit{Single-Port Porting Submodel} \quad (3)$$

where the port's pressure transfer function, $\alpha_1$, can be found by analysing the equivalent acoustic circuit.

The port-opening sound pressure, $p_1$, is transmitted through the microphone casing 2 via a cylindrical hole 7, into a larger cavity 8. The interior surfaces of the port 3 are all rigid, apart from the diaphragm 4, which forms one wall of the cavity 8. The resultant sound pressure in the cavity 8 is $p_D$, and since no sound is transmitted to the back of the diaphragm, $p_D$ is also the pressure difference across it.

In the equivalent circuit, the hole 7 is modelled by an acoustic resistance, R, in series with an inertance, M, and the cavity 8 in front of the diaphragm is modelled by an acoustic compliance, C. The diaphragm's acoustic impedance, $Z_D$, which includes the effects of a cavity 9 behind it, is in parallel with the front cavity compliance. Then:

$$\alpha_1 = 1/[1 + (R + j\omega M)(j\omega C + 1/Z_D)] \qquad (4)$$

The values of R, M and C depend on the port dimensions. The inertance of the entrance hole is due to the mass of air in it, and is given by:

$$M = \rho_0 L'/S \qquad \textit{Inertance of a hole}$$

where $\rho_0$ is the air density, S is the cross-sectional area of the hole, and L' is its effective length. The effective length of a hole which is "flanged" (penetrates a surface) at both ends is:

$$L' = L + 2(0.85a) \qquad \textit{Effective hole length (inertance)} \quad (5)$$

where L is the actual length of the hole, and a is its radius. The "extra length" is needed to model the radiation impedance at each end of the hole. The resistance of the entrance hole is also partly due to these radiation impedances, but the greater part is produced by flow resistance, due to friction on its walls. The acoustic resistance of a hole can be expressed as:

$$R = \sqrt{2\omega\mu}\, \rho_0\, L'' / (aS) \qquad \textit{Resistance of a hole, provided f/10 < 1/a <100 }\sqrt{f} \quad (6)$$

where f is frequency, $\omega = 2\pi f$, $\mu$ is the kinematic viscosity of air, and L" is the hole's effective length, which is slightly different to that in the inertance formula:

$$L'' = L + 2a \qquad \textit{Effective Hole Length (Resistance)} \quad (7)$$

Note that the resistance formula above is only valid for hole radii which lie within the frequency-dependent limits quoted. For audio frequencies, the formula applies to holes with a diameter between about 1 mm and 6 mm. The compliance of the cavity in front of the diaphragm is due to the compressibility of the air in it. If its volumre is V, its acoustic compliance is:

$$C = V/(\rho_0 c^2) \quad \textit{Compliance of a cavity} \quad (8)$$

The value of $Z_D$ depends on the mechanical properties of the diaphragm, on the mechanics of any electromechanical transducer element attached to it, and on the dimensions of the back cavity 9. It is possible to derive theoretical formulae for diaphragm impedance, dependent on these parameters. However in most cases, $1/Z_D| \ll \omega C$ at audio frequencies, so the diaphragm impedance can be neglected, and the port's pressure transfer function becomes:

$$\alpha_1 \approx 1/[1 + j\omega CR - \omega^2 CM] \qquad \textit{Helmholtz Resonator} \quad (9)$$

The port is thus a Helmholtz resonator - an acoustic version of the classical single-degree-of freedom resonator. Its pressure transfer function is close to unity at low frequencies, and rises to a peak at the resonance frequency, $f_{res}$, which is given by:

$$1/f_{res} = 2\pi\sqrt{CM} = 2\pi\sqrt{L'V/S}/c \quad \textit{Helmholtz Resonance Frequency} \quad (10)$$

However, unlike a classical resonator, the port's resistance varies with frequency. From the above formulae for M and R:

$$\omega M / R \approx \sqrt{\pi / \mu} \, a \sqrt{f} \approx 449 \, a \sqrt{f} \qquad\qquad (11)$$

where $\mu$ = 1.56 x 10$^{-5}$ m$^2$s$^{-1}$, which is the kinematic viscosity of air at temperature 20°C and pressure 101 300 Pa. It has also been assumed, in using the resistance formula, that $1/a < 100\sqrt{f}$ , and hence the following relationship will hold at all frequencies of interest:

$$\omega M/R > 4.49$$

This means that the resistance of the hole 7 will not significantly influence the port's pressure transfer function, except by limiting the magnitude of its resonance peak.

**Two Ports**

Figure 2b illustrates a two port microphone and its equivalent circuit. In this microphone, the ports 3 transmit sound pressures to respective sides of the diaphragm. The porting submodel of this two-port microphone is thus:

$$p_D = \alpha_1 p_1 - \alpha_2 p_2 \qquad\qquad \textit{Two-Port Porting Submodel} \quad (12)$$

As for the single port, the holes 7 are modelled as acoustic resistances in series with acoustic inertances, and the cavities 8, 9 either side of the diaphragm are modelled as acoustic compliances. The values of these impedances can again be calculated from the port dimensions, using the formulae given above. By analysing the acoustic circuit, the pressure transfer functions of the two ports 3 are obtained:

$$\alpha_1 = \alpha_{10}/[1 + \alpha_{10}(R_1 + j\omega M_1)/Z_D + \alpha_{20}(R_2 + j\omega M_2)/Z_D]$$

$$(13)$$

$$\alpha_2 = \alpha_{20}/[1 + \alpha_{10}(R_1 + j\omega M_1)/Z_D + \alpha_{20}(R_2 + j\omega M_2)/Z_D]$$

where

$$\alpha_{10} = 1/[1 + j\omega C_1 R_1 - \omega^2 C_1 M_1]$$

$$\alpha_{20} = 1/[1 + j\omega C_2 R_2 - \omega^2 C_2 M_2]$$

|$Z_D$| is likely to be very large at all frequencies of interest because $\alpha_{10}$ and $\alpha_{20}$ are the pressure transfer functions of the two individual ports, when isolated from each other by a diaphragm with infinite impedance. Thus $\alpha_1 \approx \alpha_{10}$ and $\alpha_2 \approx \alpha_{20}$

**Three Ports**

Figure 2c illustrates a three-port microphone and its equivalent circuit. The porting submodel of this microphone is:

$$\mathsf{pD = \alpha_1 p_1 - \alpha_2 p_2 + \alpha_3 p_3} \qquad \cdot \textit{Three-Port Porting Submodel}$$

Again, the entrance holes are modelled as resistances in series with inertances, and the cavities either side of the diaphragm are modelled as compliances. Similarly, it is assumed $|Z_D|$ is very large at all frequencies of interest, so the outer ports are isolated from the centre port. Then:

$$\cdot \; \alpha_2 = 1/[1 + j\omega C_2 R_2 - \omega^2 C_2 M_2]$$

since the centre port is a simple Helmholtz resonator, and

$$\alpha_1 = 1/[1 + (R_1 + j\omega M_1)(j\omega C_1 + 1/(R_3 + j\omega M_3))]$$

$$\tag{14}$$

$$\alpha_3 = 1/[1 + (R_3 + j\omega M_3)(j\omega C_1 + 1/(R_1 + j\omega M_1))]$$

If the two outer ports have entrance holes with the same dimensions, then $R_1 = R_3$, $M_1 = M_3$, and their pressure transfer functions become identical:

$$\alpha_1 = \alpha_3 = 1/[2 + j\omega C_1 R_1 - \omega^2 C_1 M_1] \qquad\qquad \tag{15}$$

It can be seen that at low frequencies the centre port's pressure transfer functions tends to unity, but the outer ports' tend to 1/2.

**The Electromechanical SubModel**

A microphone's electromechanical submodel calculates the output voltage, v, produced by pressure difference pD across its diaphragm. The form of this submodel depends on the design of (i) the microphone's diaphragm and transducer element and (ii) the electronic circuitry on the microphone's output.

There are many transduction principles, by which a pressure difference across a diaphragm can be converted to an electrical signal. The more common ones include the moving coil and magnet used in "dynamic" microphones, and the piezoelectric materials used in "ceramic" microphones. However, almost all modern handsets, use electret condenser microphones and thus only an electromechanical submodel for such a microphone will be considered. A condenser microphone is basically a parallel-plate capacitor, with its diaphragm forming one of the plates. A pressure difference across the diaphragm causes it to move towards or away from the other plate (the "backplate"), which alters the capacitance. When a bias charge is held in the capacitor, variations of its capacitance are converted into variations of the voltage across it. In an electret condenser microphone, the bias charge is supplied by a piece of material which is permanently electrically polarised, i.e. an electret. (The temperature sensitivity of such microphones occurs because electrets lose their polarisation above a certain temperature). For high sensitivity and low noise, a condenser microphone needs a high input-impedance preamplifier connected directly to it, and in commercial electret microphones this is provided by a FET integrated into the capsule.

The FET output voltage, $v_{FET}$, is given by:

$$\mathsf{v_{FET} = \beta pD} \qquad\qquad \textit{Electret Condenser Microphone} \quad (16)$$

where the pressure sensitivity, $\beta$, is usually constant across the frequencies at which the microphone is designed to operate. There will be a low-frequency roll-off of pressure sensitivity, because the microphone's capacitance and the FET's input resistance forms a high-pass filter, but this usually falls below the frequencies of interest for handset microphones.

It is often useful to modify a microphone's frequency response with additional filter circuitry following the FET preamplifier, and we will include the effects of such circuitry in the electromechanical submodel. Hence, the microphone output voltage, v, is given by:

$$v = \gamma p D \qquad \qquad \textit{Electromechanical Submodel \quad (17)}$$

where $\gamma$ is the product of $\beta$ with the output circuitry's transfer function.

By combining the three submodels above, namely the sound-field, porting and electromechanical submodels, the following equation is obtained for the output voltage of a handset microphone with N ports, due to a point monopole sound source:

$$v = \gamma \, A \sum_{n=1}^{N} \pm \alpha_n \, e^{-jkr_n} / r_n \qquad \qquad \textit{Generalised Microphone Model \quad (18)}$$

Dividing this by the sound pressure at the mouth of port 1, gives an expression for this microphone's sensitivity to a point source:

$$S = \gamma \sum_{n=1}^{N} \pm \alpha_n \, (r_1 / r_n) \, e^{-jk(r_n - r_1)} \qquad \qquad \textit{Sensitivity to a point source}$$

$$\textit{(19)}$$

A microphone's sensitivity is independent of the amplitude of the source. However, as mentioned above, it generally still depends on its position.

**Speech and Background Noise Models**

The microphone models can be used to predict a microphone's sensitivity to a point monopole sound source in a free field. To calculate the sensitivity of a handset microphone to a user's speech, for example, and to background noise, these sound fields need to be modelled in terms of such point sources. The speech model below does this.

**The Speech Model**

The speech model expresses the user's speech sound field as a summation of spherical waves radiated by point monopole sources in a free field. Measurements have shown that the sound radiation pattern of the human voice can be quite accurately modelled by assuming it is a single point monopole source, centred just behind the lips. This is exemplified in Figure 3 which compares two plots of speech sound pressure level against distance in front of the lips: one measured and the other calculated for a point source 7 mm behind the lips.

It can be seen that the curves are nearly identical, except that the speech level predicted by the model becomes slightly too high at positions very close to the lips. Since a handset microphone is unlikely to be held more or less on the lips, the point source model is accurate enough model. Thus, ignoring reflection or diffraction by any other nearby objects, we can model the speech sound field as a single spherical wave, whose sound pressure is given by:

$$p_s = A_s \, e^{-jkr_s} / r_s \qquad \qquad \textit{Speech Model \quad (20)}$$

Here $r_s$ is the distance from the lips plus 7 mm, and $A_s$ defines the frequency-dependent magnitude and phase of the speech sound wave.

**The Background Noise Model**

The background noise model expresses the noise sound field as a summation of spherical waves radiated by point monopole in a free field. The noise sound pressure field is thus:

$$p_b = \Sigma \ A_{bi} \ e^{-jkr_{bi}} \ / \ r_{bi} \qquad\qquad Background\ Noise\ Model\ \ (21)$$

where $r_{bi}$ is the distance from the ith point source, and $A_{bi}$ is its amplitude. The values of $A_{bi}$ and $r_{bi}$ will obviously vary considerably, depending on the noise environment in which the mobile telephone is used. The noise sources might be concentrated in certain directions, or spread all around the handset, and there could be some dominant sources, or many of roughly equal amplitude. However, it can generally be assumed that all noise sources will be much further from the handset microphone than the speech source. Since reflection and diffraction by objects near the handset is being ignored, it can also be assumed that all the point sources in the noise model will be relatively distant from handset.

An "average" background noise field can be modelled by taking a large number of point noise sources whose magnitudes, $|A_{bi}|$, are equal but whose phases are random. When these sources are uniformly distributed at all angles around the handset, but at the same distance from it, the result is an ideal "diffuse" sound field, such as is often used to model acoustic noise.

The microphone models enable the sensitivity of a handset microphone to a point source of sound to be calculated, and in the speech and background noise models were developed in terms of such sources. Thus these models can be combined to find equations for the speech and noise sensitivities of various types of handset microphone. These equations can then be used to evaluate the speech reception performances of the microphones.

**Single-Port (Pressure) Microphones**

The simplest type of handset microphone is that, shown in Figure 2a, which is already employed in various handsets. A microphone capsule has sound transmitted to it by a single port 7. The port leads through the casing 2 to one side of the diaphragm 4, and the diaphragm's other side is surrounded by a closed cavity 5. In this case, the generalised microphone sensitivity equation, equation 19, reduces to the simple form:

$$S = \gamma\alpha_1 \qquad\qquad Single\ Port\ Microphone\ Sensitivity\ \ (22)$$

The sensitivity of a single-port microphone to a point source is thus independent of the distance or direction of the source. A single-port microphone is often known as a "pressure" microphone, because it can be used to measure the sound pressure at any position in a sound field.

Clearly, the speech and noise sensitivities of a pressure microphone are equal: there is no discrimination against noise sources. Thus the microphone's output speech signal to noise ratio can only be raised by moving the microphone closer to the user's mouth, as can be seen from Figure 3. However, substantial gains in SNR are realistically achieved by using microphones which discriminate against background noise.

**Two-Port (First-Order) Microphones**

A two-port handset microphone such as that shown in Figure 2b is also already employed in various handsets. Such a handset employs a microphone capsule which has ports 3 leading to both sides of the diaphragm 4. From equations 12 and 17, the output voltage of a two-port microphone is given by:

$$v = \gamma[\alpha_1 p_1 - \alpha_2 p_2]$$

where $p_1$ and $p_2$ are the sound pressures at the openings of the ports. Let the distance between the port mouths be $\Delta x$. In a handset microphone, $\Delta x$ will be much smaller than any wavelength of interest, so $p_2$ can be expressed in terms of the pressure and its gradient at port opening 1:

$$k\Delta x \ll 1 \Rightarrow p_2 \approx p_1 + \Delta x \, \partial p_1/\partial x \quad \textit{First Order Approximation} \quad (23)$$

Thus:

$$v \approx \gamma \left[ (\alpha_1 - \alpha_2) \, p_1 - \alpha_2 \, \Delta x \, \partial p_1/\partial x \right]$$

The output voltage of a two-port microphone is thus approximately proportional to a combination of the sound pressure and its first spatial derivative at the microphone. For this reason, two-port microphones are sometimes known as "first-order" microphones. If the pressure transfer functions of the ports are equal, $\alpha_1 = \alpha_2$, the microphone is called a "pressure-gradient" microphone, because its output voltage is proportional to the sound pressure gradient alone:

$$v \approx - \gamma \, \alpha_2 \, \Delta x \, \partial p_1/\partial x \qquad \textit{Pressure gradient microphone} \quad (24)$$

When the incident sound comes from a point source, the sensitivity of a generalised two-port microphone can be determined from equation 19:

$$S = \gamma \left[ \alpha_1 - \alpha_2 \, (r_1 / r_2) e^{-jk(r_2 - r_1)} \right] \quad \textit{Two Port Microphone Sensitivity} \; (25)$$

This will vary with the position of the source, because it depends on the source's distances from the two port openings, $r_1$ and $r_2$. To see more clearly how sensitivity varies with source position, it is useful to rewrite the above equation in terms of $r_1$ and $\theta$, which is the source's angle off the microphone axis,( i.e. the line through the port mouths). Figure 4 illustrates this geometry.

From Figure 4, it can be determined that:

$$r_2{}^2 = (r_1 + \Delta x \cos\theta)^2 + \Delta x^2 \sin^2\theta$$

Substituting this equation for $r_2$ into equation 25 gives a rather complicated result, but it can be simplified by making certain approximations, $(r_2 - r_1) \leq \Delta x$ and $k\Delta x \ll 1$. Hence:

$$k(r_2 - r_1) \ll 1 \Rightarrow e^{-jk(r_2 - r_1)} \approx 1 - jk(r_2 - r_1) \quad \textit{First Order Approximation} \quad (26)$$

and the sensitivity to a point source (either speech or noise) becomes:

$$S \approx \gamma [\alpha_1 - \alpha_2 (r_1/r_2)(1 - jk(r_2 - r_1))] \quad (27)$$

From equation 27, it can be seen that the magnitude of sensitivity is generally increased when $(r_2 - r_1)$ is large. This can be achieved by making the distance between the port openings, $\Delta x$, large but that increases the sensitivities to speech and noise equally. The value of $(r_2 - r_1)$ is also greatest for sources on the microphone axis. Thus the first-order microphone's speech sensitivity, can be maximised without increasing its overall sensitivity to background noise, by making sure that the speech source is close to the microphone's axis. This is done in the present invention by arranging the two handset microphone ports so that they line up with the mouth when the telephone is in normal usage. So, for the point source which models the user's speech:

$$\theta \approx 0 \Rightarrow r_2 \approx r_1 + \Delta x$$

The speech (or on-axis) sensitivity of a generalised first-order microphone is thus:

$$S_S \approx \gamma \left[ \alpha_1 - \alpha_2(1 - jk\Delta x)/(1 + \Delta x/r_{s1}) \right] \qquad \textit{Speech (on-axis) sensitivity} \quad (28)$$

This varies with $r_{s1}$, the distance of the mouth of microphone port 1 from the point speech source. Consider, for example, a pressure-gradient microphone, for which $\alpha_1 = \alpha_2$. Its speech sensitivity is given by:

$$S_S \approx \gamma \, \alpha_2 \, \Delta x \, (1 + jkr_{s1})/(r_{s1} + \Delta x) \qquad \textit{Pressure Gradient Microphone} \quad (29)$$

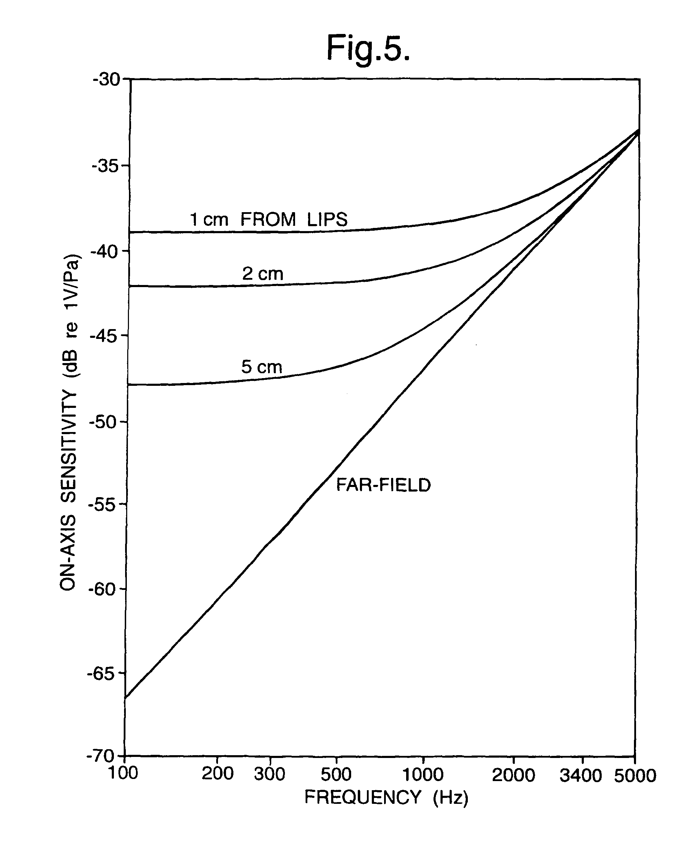

As it can be seen from equation 29, not only will the overall level of its speech sensitivity vary with distance from the user's mouth, but also the frequency-dependence of the sensitivity. Figure 5 illustrates this. This figure contains plots of on-axis sensitivity against frequency for a pressure-gradient microphone with its port openings $\Delta x = 5$ mm apart, held at four distances from the user's lips. (Note that, in accordance with the speech model, a microphone's distance from the lips is defined as $r_{s1}$ minus 7 mm. Arbitrary values of $\gamma = 0.05$ VPa$^{-1}$ and $\alpha_2 = 1$, have been assumed at all frequencies).

As can be seen from Figure 5, when the microphone is far from the source, its on-axis sensitivity is proportional to frequency. As the microphone is moved in towards the lips, it speech sensitivity increases greatly and "flattens out" at low frequencies, whereas at high frequencies it continues to slope up, and only increases marginally. The rate of change of sensitivity with distance is largest close to the lips.

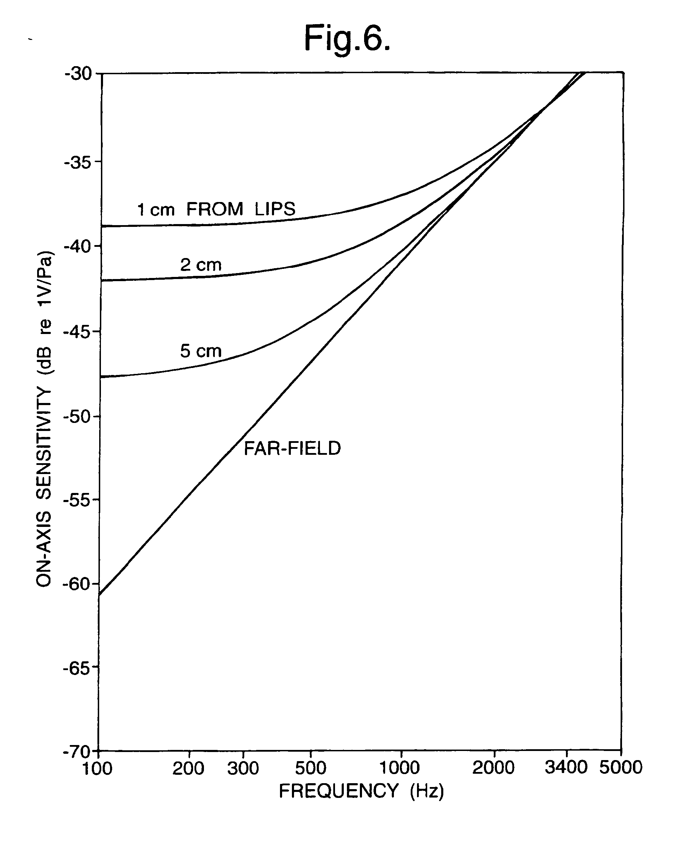

For first-order microphones where $\alpha_1$ does not equal $\alpha_2$, the speech sensitivity will follow the aforementioned pattern, but its variation with distance from the lips will be smaller. This is because the microphone's output then has a component proportional to sound pressure, as well as pressure gradient, so its response lies somewhere between the responses of a pressure microphone and a pressure-gradient microphone. This is exemplified in Figure 6, which is for a microphone that is the same as above, except that $\alpha_1 = 1$ but $\alpha_2 = 1/[1 + j\omega C_2 R_2]$ because port 2 has a relatively large acoustic resistance, $R_2$. (It has been assumed that $C_2 R_2 = \Delta x/c$, which is actually a "cardioid" microphone - see below).

The far-field on-axis sensitivity of this microphone is 6 dB greater than that of the pressure-gradient microphone, at all frequencies. Its on-axis (speech) sensitivity at 1 cm from the lips is also higher at high frequencies, but is similar to that of the pressure-gradient microphone at low frequencies. Overall, the sensitivity variation with distance form the lips is smaller.

In the noise model it is assumed that all background noise sources will be relatively distant from the handset. Hence, for a point source of noise:

$$r_1 >> \Delta x \Rightarrow r_2 \approx r_1 + \Delta x \cos\theta \approx r_1 \qquad\qquad (30)$$

The noise sensitivity of a generalised first-order microphone is thus:

$$S_{ff} \approx \gamma[\alpha_1 - \alpha_2 \, (1 - jk\Delta x \cos\theta)] \qquad \textit{Far-Field (Noise) Sensitivity} \quad (31)$$

This "far-field" sensitivity is independent of the course's distance from the microphone, but varies with its angle, $\theta$, off the microphone axis. Its magnitude is generally greatest on axis, at $\theta = 0$. As we would expect from considerations of symmetry, sensitivity is independent of the polar angle, $\phi$, about the microphone's axis.

The difference between a handset microphone's speech and noise sensitivities its "noise discrimination". It is useful to consider the noise discrimination of a first-order microphone in two parts. Firstly, the microphone is generally less sensitive to noise sources on its axis than to the nearby speech source on its axis. Secondly, it is even less sensitive to noise sources at angles off its axis than to on-axis noise sources. These two parts of noise discrimination are discussed below.

*On-Axis Noise Discrimination*

The sensitivity of a first-order microphone to a noise source on its axis is:

$$S_{ffoa} \approx \gamma [\alpha_1 - \alpha_2 + jk\Delta x \, \alpha_2] \qquad \textit{On-Axis Far-Field Sensitivity} \quad (32)$$

The on-axis noise discrimination of a handset microphone is the ratio of this sensitivity to its speech sensitivity, expressed in decibels:

$$ND_{oa} = 20 \log_{10} |S_{ffoa}/S_s| \qquad \textit{On-Axis Noise Discrimination} \quad (33)$$

Note that any discrimination against noise results in a negative value of $ND_{oa}$. From equations 29 and 31, it can be seen that the noise discrimination can be improved by providing a microphone with appropriate values of four parameters: $\alpha_1$ and $\alpha_2$, the pressure transfer functions of the two ports; $\Delta x$, the distance between their mouths; and $r_{s1}$, the distance of port 1 from the speech source.

If port 2 was closed off, so $\alpha_2 = 0$, the microphone would be a single-port pressure microphone, with a noise discrimination of 0 dB. If a pressure-gradient microphone was used, for which $\alpha_1 = \alpha_2$, the on-axis noise discrimination would be:

$$ND_{oa} \approx 20 \log_{10} \left[ k(r_{s1} + \Delta x) / \sqrt{1 + k^2 \, r_{s1}^2} \right] \qquad \textit{Pressure} \qquad \textit{Gradient}$$

*Microphone (34)*

This will be much less than 0 dB at most frequencies of interest, for typical values of $r_{s1}$ and $\Delta x$.

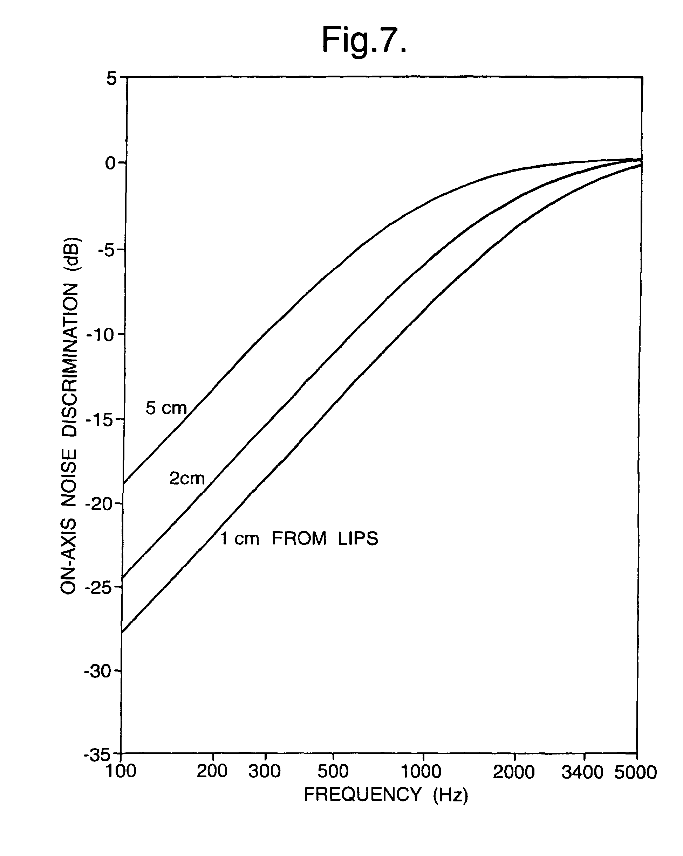

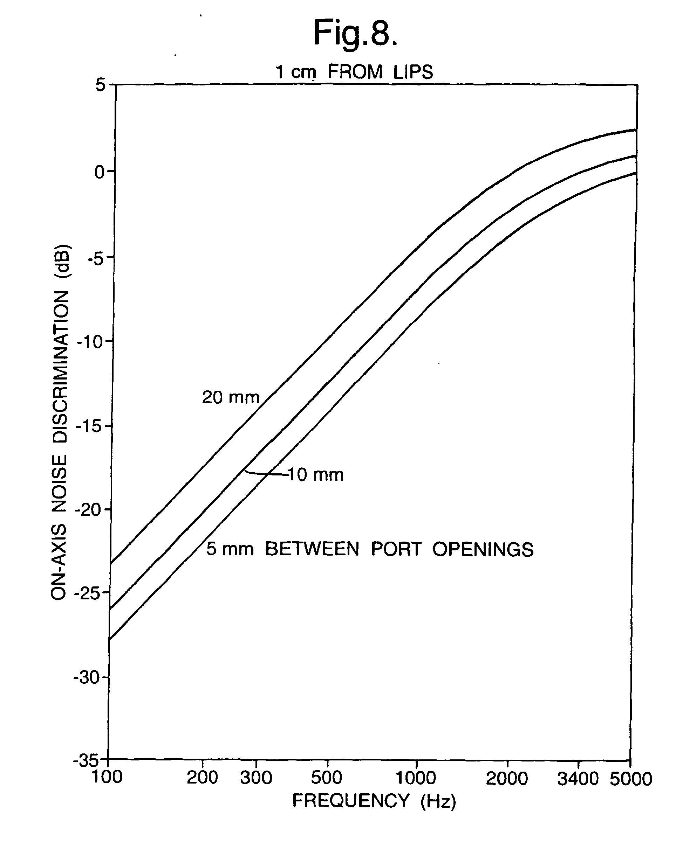

Figures 7 and 8 are plots of on-axis noise discrimination against frequency for different values of parameters $\Delta x$ and $r_{s1}$. Figure 7 shows the noise discrimination against frequency for a microphone having port openings 5mm apart at different distances from the user's lips. Figure 8 shows the noise discrimination against frequency for microphones having different distances between their port openings, and being a constant distance of 1cm from the user's lips.

Figures 7 and 8 show that pressure-gradient microphones give good discrimination against on-axis noise at the lower frequencies of interest; up to about 18 dB at 300 Hz. Around 3.4 kHz they give little discrimination, and may even be slightly more sensitive to on-axis noise than speech, if $\Delta x$ is large. From the above equation, we can see that the noise discrimination is greatest, at all frequencies, when $(r_{s1} + \Delta x)$ is made as small as possible. This is achieved in preferred embodiments of the invention by positioning the microphone near to the user's mouth, and by putting the two port openings close together.

For first-order microphones where $\alpha_1$ does not equal $\alpha_2$, the on-axis noise discrimination will generally be less than that of a pressure-gradient microphone with the same values of $r_{s1}$ and $\Delta x$. This can be seen from Figures 5 and 6: on-axis noise discriminations can be obtained from these sensitivity plots by taking the difference in decibels between the upper curves (speech sensitivities) and the bottom curve, which is the far-field (noise) on-axis sensitivity. The on-axis noise discriminations of the pressure-gradient microphone in these examples are markedly greater than those of the first-order microphone, especially at lower frequencies.

*Directional Noise Discrimination*

The radio of a microphone's sensitivity to a point source in its far field at angle $\theta$ off its axis to its on-axis far-field sensitivity is known as its far-field directivity:

$$D_{ff} = D_{ff}/S_{ffoa} \qquad \textit{Far-Field Directivity} \quad (35)$$

Equation 31 for the far-field (noise) sensitivity of a generalised first-order microphone can be rewritten in the form:

$$S_{ff} \approx \gamma \, [1 + B\cos\theta]$$

where

$$B = jk\Delta x \, \alpha_2/(\alpha_1 - \alpha_2)$$

and hence the far-field directivity of a generalised first-order microphone is:

$$D_{ff} = (1 + B\cos\theta)/(1 + B)$$

It is conventional to replace B with the parameter K, given by:

$$K = B/(1+B) = 1/[1 + (\alpha_1 - \alpha_2)/jk\Delta x\alpha_2]$$

The far-field directivity of a generalised first-order microphone is then:

$$D_{ff} = 1-K + K\cos\theta \qquad \textit{First Order Microphone \quad (36)}$$

The far-field directivity indicates how much discrimination a microphone has against off-axis noise sources, in comparison with an on-axis noise source. From equation 36 it can be seen that the directivity of a first-order microphone can be altered by changing its value of K, which depends in turn on the pressure transfer functions of the two ports, $\alpha_1$ and $\alpha_2$, and the distance between their mouths, $\Delta x$.

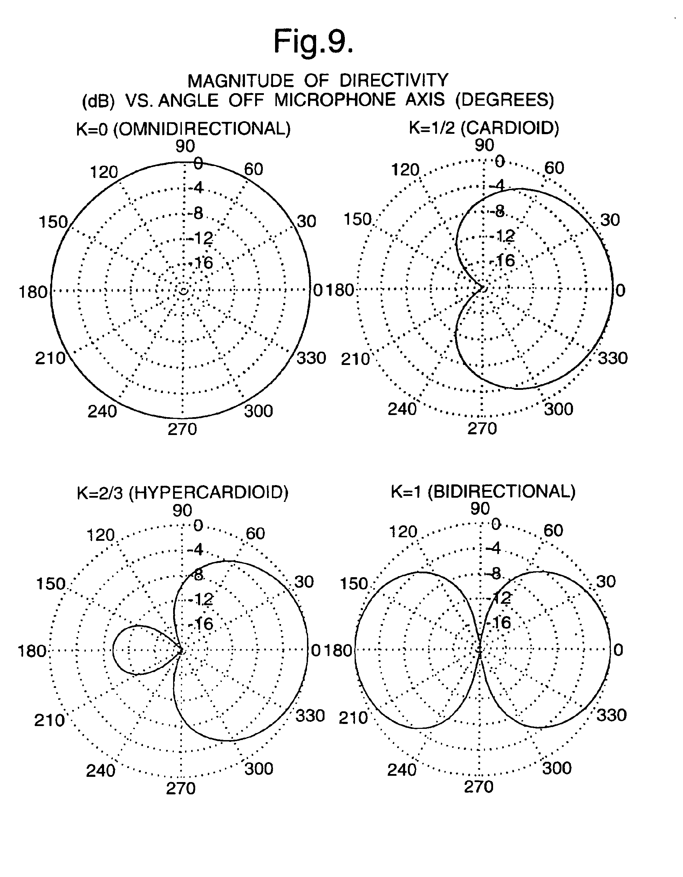

Figure 9 illustrates far-field directivities for four values of K. When port 2 is closed off, so $\alpha_2 = 0$ and K $=0$, then from equation 36 $D_{ff} = 1$ (0 dB) at all angles, and the microphone is omnidirectional, as expected from a single-port microphone. The other extreme is a pressure-gradient microphone, whose ports have equal pressure transfer functions, so K = 1 and $D_{ff} = \cos\theta$. This form of directivity is called bidirectional, because it is high in two opposite directions, and low in between.

When the pressure transfer functions of the two ports are unequal, the magnitude of K generally lies between zero and one, and the microphone is unidirectional, i.e. its directivity is highest around one particular angle. Figure 9 shows the directivity patterns for K = 1/2 and 2/3. The former is called "cardioid", because it is heart-shaped, and the latter is known as "hypercardioid".

In all cases, a first-order handset microphone is less sensitive to background noise coming from angles off its axis than to on-axis noise, and there are certain angles at which its sensitivity is particularly low. This means that, if most of the background noise comes from one particular source, the user could potentially orientate his handset so that the noise source is at an angle of minimum sensitivity, and thereby obtain a very high degree of noise rejection. In order to minimise the noise on the microphone output, the user would need to be able to hear it reasonably clearly, via the handset's sidetone.

Even if the noise comes fairly uniformly from all directions, a first-order microphone will pick up less of it than a pressure microphone which has the same far-field sensitivity at θ-0. The ratio in decibels of the magnitudes of the sensitivities of these two microphones to a diffuse sound field is known as the diffuse-field directivity factor of the first-order microphone. As described above, a diffuse field is produced by an infinite number of point sources of random phase but equal magnitude, at the same (large) distance from the microphone, and uniformly distributed over all angles around it. the diffuse-field directivity factor of a microphone is hence given by:

$$DF = 10 \log_{10} \left[ \int_{\phi=0}^{2\pi} \int_{\theta=0}^{\pi} \left| D_{ff} \right|^2 \sin\theta \, d\theta \bigg/ \int_{\phi=0}^{2\pi} \int_{\theta=0}^{\pi} \sin\theta \, d\theta \right]$$

where $D_{ff}$ is its far-field directivity. Since $D_{ff}$ depends only on $\theta$, this simplifies to:

$$DF = 10 \log_{10} \left[ 1/2 \int_{\theta=0}^{\pi} \left| D_{ff} \right|^2 \sin\theta \, d\theta \right] \qquad (37)$$

Substituting equation 36 into equation 37 gives:

$$DF = 10 \log_{10} [(1-K)^2 + K^2/3] \qquad \textit{Diffuse-Field Directivity Factor} \quad (38)$$

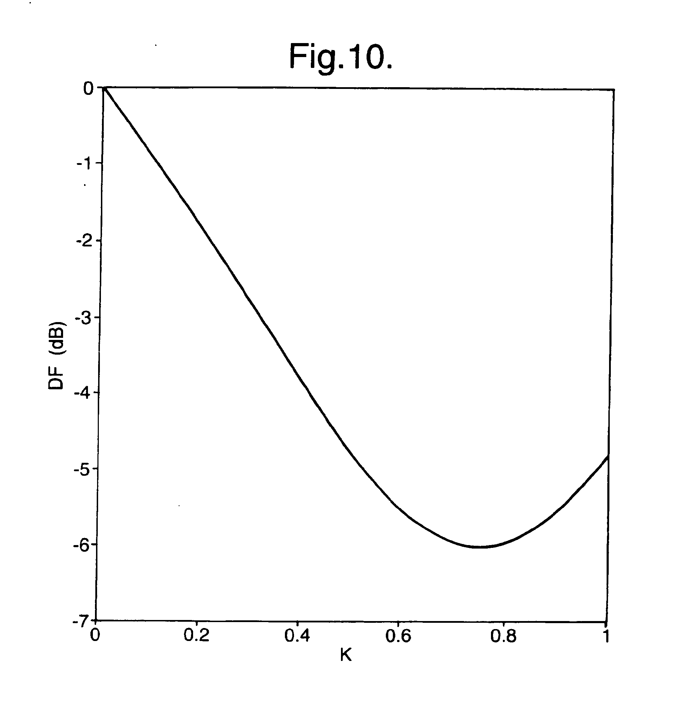

Figure 10 shows the diffuse-field directivity factor of a first-order microphone for K between zero and one according to equation 38. It is less than 0 dB for all K> 0, showing that any first-order microphone will pick up less diffuse noise than an omnidirectional pressure microphone. Its minimum of -6 dB occurs when K = 3/4 (which corresponds to "supercardioid" directivity), but any value of K between 1/2 and 1 will give nearly as much discrimination against diffuse noise.

The overall speech reception performance of a first-order handset microphone under given operating conditions, can be calculated by combining its on-axis noise discrimination of -10 dB at 500 Hz, and a directivity of -5 dB at 60° off axis, then its output SNR will be 15 dB better than that of a pressure microphone, for a noise source at this frequency and angle. A good measure of the microphone's discrimination against "average" background noise is obtained by adding its diffuse-field directivity factor to its on-axis noise discrimination, to give a diffuse-field noise discrimination:

$$Nd_{df} = Nd_{oa} + DF \qquad \textit{Diffuse-Field Noise Discrimination} \quad (39)$$

### Three-Port (Second-Order) Microphones

A three-port microphone is shown in Figure 2c. It can be used in a handset by employing the same sort of microphone capsule as a two-port microphone, but with two separate ports leading to one side of this capsule. As shown in Figure 2c, two if the ports, ports 1 and 3, transmit sound to the front of the diaphragm, and the other port, port 2, transmits sound to the back. From the microphone model, the output voltage of this microphone is:

$$v = \gamma[\alpha_1 p_1 - a_2 p_2 + \alpha_3 p_3] \qquad (40)$$

where $p_1$, $p_2$ and $p_3$ are the sound pressures at the openings of the ports. Assuming that the port openings are evenly spaced $\Delta x$ apart along a line, where $k\Delta x \ll 1$ at all frequencies of interest, $p_2$ and $p_3$ can be expressed in terms of the pressure and its spatial derivatives at port opening 1:

$$p_2 \approx p_1 + \Delta x \partial p_1 / \partial x + (\Delta x^2/2) \partial^2 p_1 / \partial x^2$$

*Second Order Approximation (41)*

$$p_3 \approx p_1 + 2\Delta x \partial p_1 / \partial x + 2\Delta x^2 \partial^2 p_1 / \partial x^2$$

Three-port microphones are also known as "second-order" microphones, because their output voltage can be expressed as a linear combination of the sound pressure and its first and second spatial derivatives at the microphone, by substituting the approximations in equations 41 into equation 40. This gives a rather complicated result, except in the special case when the pressure transfer functions of the two outer ports are exactly half that of the centre port; $\alpha_1 = \alpha_3 = \alpha_2/2$. In this case, a microphone output is proportional to the "pressure gradient gradient" alone:

$$v \approx \gamma \alpha 2 (\Delta x^2/2) \partial^2 p1 / \partial x^2$$

*PGG Microphones   (42)*

From equation 19, the sensitivity of the pressure-gradient-gradient (PGG) microphone to a point source is:

$$S = \gamma \alpha_2 \left[ 1/2 - (r_1/r_2)e^{-jk(r_2-r_1)} - 1/2(r_1/r_3)e^{-jk(r_3-r_1)} \right]$$

*PGG       Microphone Sensitivity*

Since $k(r_2-r_1) \ll 1$ and $k(r_3-r_1) \ll 1$ for all frequencies of interest, the following approximations can be used to analyse the microphone's sensitivity to speech and noise sources:

$$e^{-jk(r_n-r_1)} \approx 1 - jk(r_n - r_1) - k^2(r_n - r_1)^2/2$$

*Second Order Approximation (43)*

As for a first-order microphone, the sensitivity is greatest to sources on the microphone axis. Thus, in an embodiment of the present invention the port openings of a PGG handset microphone are arranged so that they are lined up with the user's mouth. So, for the point source which models the user's speech:

$$\theta \approx 0 \Rightarrow r_2 \approx r_1 + \Delta x \text{ and } r_3 \approx r_1 + 2\Delta x$$

Using these approximations, the following expression is obtained for the speech sensitivity of a PGG microphone:

$$S_s \approx \gamma \alpha_2 \Delta x^2 [1 + jkr_{s1} + k^2 r_{s1}^2/2]/[(r_{s1} + \Delta x)(r_{s1} + 2\Delta x)]$$

*Speech sensitivity (44)*

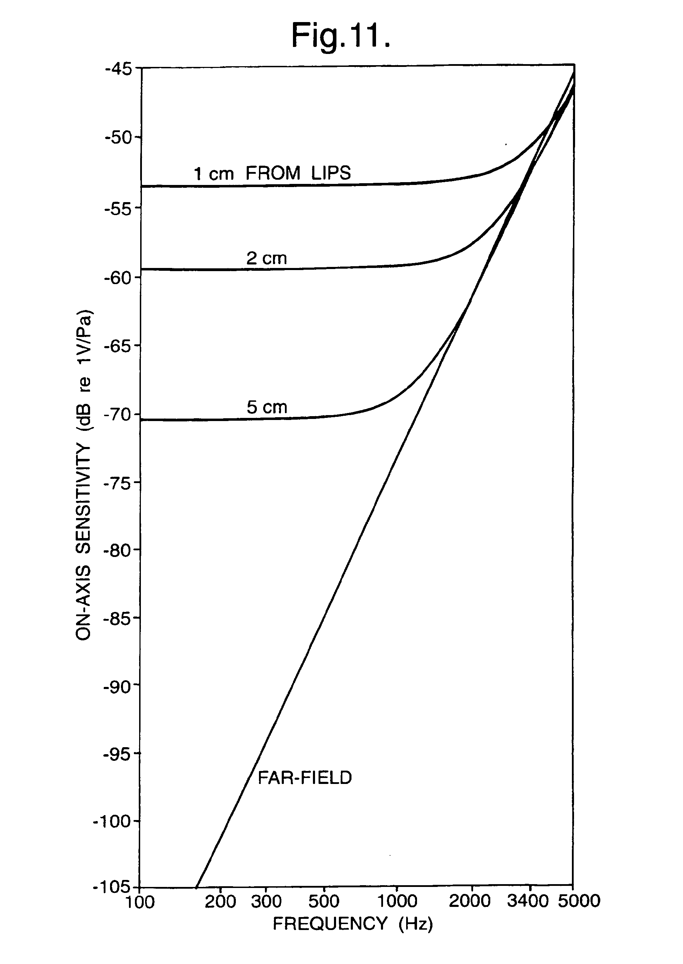

This varies with $r_{s1}$, the distance of the mouth of microphone port 1 from the point speech source. The variations are similar in form to those of a first-order microphone, but greater in magnitude. This can be seen by comparing Figures 5 and 6 with Figure 11. Figure 11 shows plots of speech sensitivity against frequency for a PGG microphone with its port openings spaced at $\Delta x = 5$ mm, held at four distances from the user's lips. (As before, arbitrary values of $\gamma = 0.05$ Vpa$^{-1}$ and $\alpha_2 = 1$ have been assumed, at all frequences).

As can be seen from Figure 11, when the microphone is far from the source, its on-axis sensitivity is proportional to the square of frequency. As the microphone is moved in towards the lips, its speech sensitivity increases greatly and "flattens out" at low frequencies, whereas at high frequencies it continues to slope up, and only increases marginally.

The rate of change of sensitivity with distance is largest close to the lips. As with first-order microphones, the results of these sensitivity variations will be changes in the level and frequency coloration of the microphone's speech output, as the user moves his handset.

From the noise model, assuming that all background noise sources will be relatively distant from the handset, for point sources of noise, in the far field of the microphone:

$$r_2 \approx r_1 + \Delta x \cos\theta \approx r_1 \text{ and } r_3 \approx r_1 \text{ } 2\Delta x \cos\theta \approx r_1$$

where $\theta$ is the source's angle off axis. Substituting these approximations into the sensitivity equation, the following expression for the noise sensitivity of a PGG microphone is obtained:

$$S_{ff} \approx - \gamma\alpha_2 (k^2 \Delta x^2/2) \cos^2\theta \quad \textit{Far-field (Noise) Sensitivity} \quad (45)$$

This is independent of the noise source's distance from the microphone (as long as it is a large distance), but varies with $\theta$. As for a first-order microphone, we can consider the noise discrimination of a PGG microphone in two parts. Firstly, the microphone is less sensitive to noise sources on its axis than to the nearby speech source. Secondly, it is even less sensitive to noise sources at angles off its axis.

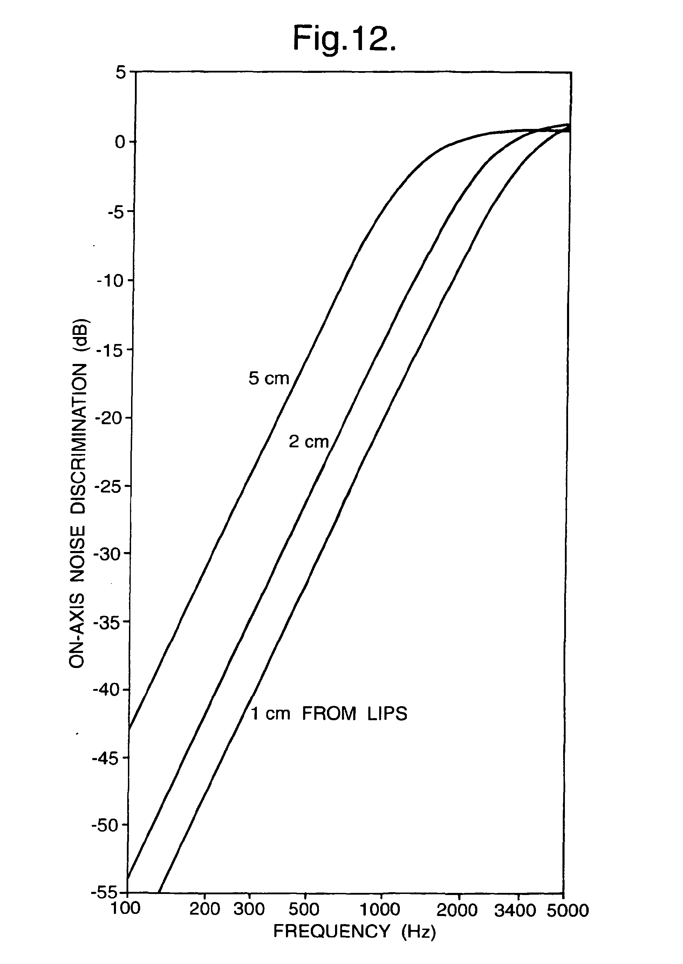

Figure 12 is a graph of on-axis noise discrimination against frequency for a PGG microphone with its port mouths spaced at $\Delta x = 5$ mm, held at three distances from the user's lips. The plots are similar in form to those for the pressure-gradient microphone in Figure 7, but the magnitudes of on-axis noise discrimination are much larger. The PGG microphone gives up to 41 dB noise discrimination at 300 Hz. At around 3.4. kHz it gives little discrimination, and may even be slightly more sensitive to on-axis noise than speech.

The far-field directivity of a PGG microphone is simply:

$$D_{ff} = \cos^2\theta \quad \textit{Far-field directivity} \quad (46)$$

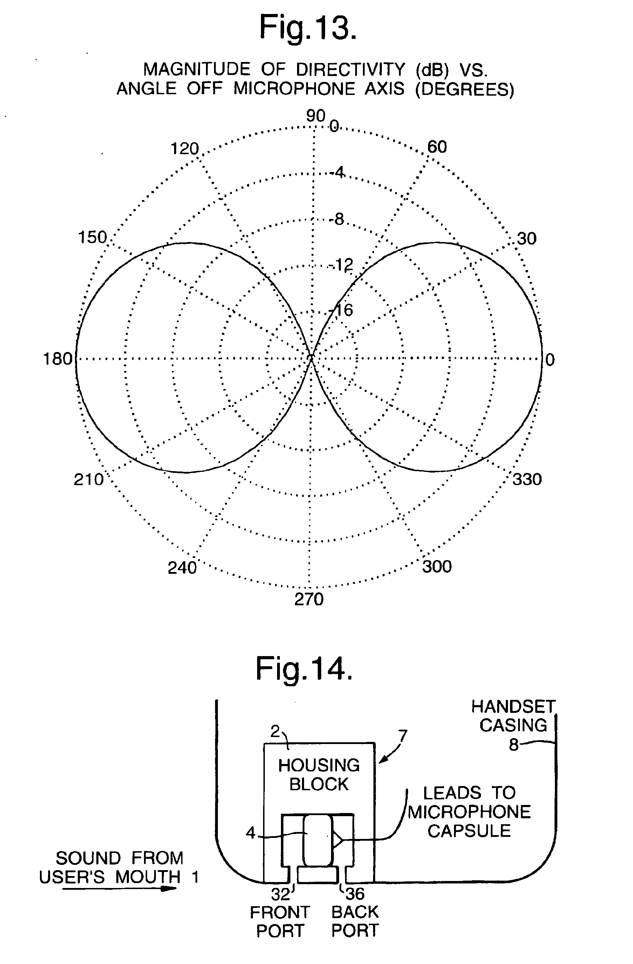

which is plotted in Figure 13. This is a bidirectional pattern, similar to that of a pressure-gradient microphone, but with narrower lobes. A PGG microphone will thus give more discrimination against off-axis noise than a pressure-gradient microphone. the diffuse-field directivity factor of a PGG microphone is -7dB.

A PGG microphone will give considerably more noise discrimination than a first-order microphone, provided that its pressure transfer functions satisfy $\alpha_1 = \alpha_3 = \alpha_2/2$. Any substantial deviation from this relationship however results in a degraded performance.

One way of achieving the correct pressure transfer function ratios for a PGG microphone is to use Helmholtz-resonator-type ports. An alternative approach is to use a differential microphone array. However, usually first-order microphones give quite enough noise discrimination for most environments, especially when held close to the lips.

**Microphone arrays**

Discrimination against background noise can also be obtained using a microphone array, i.e. two or more microphones whose output signals are electrically combined into one.

In an embodiment of the invention, the handset microphone is a differential array. In such an array, microphones are positioned close together, in comparison with the sound wavelengths of interest, and some of the microphone outputs are subtracted from the others to give the array output signal. The simplest type of differential array used two pressure microphones placed next to each other, with one output subtracted from the other. This is actually another form of first-order microphone, in which the sound pressure difference signal is produced electrically, rather than by transmitting sound to either side of a diaphragm. In a similar way, a second-order microphone can be synthesised from two first-order microphones, or from three pressure microphones.

The speech reception performances of differential arrays are basically the same as those of equivalent single microphones with multiple ports. However, the fact that the sound signals are added electrically allows greater design flexibility than with a single microphone. For example, the output voltage of a first-order array will be:

$$v = v_1 - v_2$$

where $v_1$ and $v_2$ are the outputs of two pressure microphones, given by:

$$v_1 = \gamma_1 \alpha_1 p_1 \text{ and } v_2 = \gamma_2 \alpha_2 p_2$$

The array output is thus:

$$v = \gamma_1 \alpha_1 p_1 - \gamma_2 \alpha_2 p_2 \qquad \textit{First Order Array}$$

and the output of a single first-order microphone is:

$$v = \gamma[\alpha_1 p_1 - \alpha_2 p_{2]} \qquad \textit{First-order microphone}$$

Whereas the noise discrimination of the single microphone is controlled by the ration of its two port pressure transfer functions $\alpha_1$ and $\alpha_2$, the array's noise discrimination can also be adjusted by varying the gains on the outputs of its two pressure microphones $\gamma_1$ and $\gamma_2$. Speech reception performance may be optimised by altering the array electronics rather than by redesigning the microphone ports. Also, the porting arrangement is less complicated.

Preferably, either microphone capsules with very accurately known sensitivities would be needed, or the microphone output gains would need to be adjusted to maintain the microphone sensitivity ratio.

If the ratio $\gamma_1 \alpha_1 / \gamma_2 \alpha_2$ cannot be kept within the required tolerance limits, compensation for any sensitivity mismatch should be effected by measuring the array response, and adjusting the microphone output gains. Such an "autocalibration" system would ideally be built into the handset, so that it could counteract the effects of microphone ageing. For really accurate matching of microphone responses, their outputs could be passed through digital filters, which would be adaptively adjusted to optimise the array response.

From the above models, it is apparent that noise discrimination can be optimised if a noise cancelling microphone has its port openings along the microphone axis (i.e. the axis along which the microphone port openings and the point source appear), whatever the structure or type of the noise cancelling microphone. For example, Figure 14 shows a basic structure of a handset of an embodiment of the present invention. This handset comprises a first-order (2 port) microphone 7 within a handset casing 8. The microphone comprises a housing block 2 within which is positioned a diaphragm 4. One side of the diaphragm is coupled to a front port 3a and the other side is coupled to a back port 3b. In use, the handset is positioned such that the front and back port openings are substantially aligned with the user's mouth. Hence, the sound source and the front and back openings are positioned along the microphone axis, and noise discrimination is improved over handsets having omnidirectional microphones, for example. Preferably, the handset is sized such that this positional arrangement can be achieved with the port openings on the base of the handset. Also, it is advantageous if the port openings are close together (e.g. see figure 8) as this further improves the noise discrimination. Further, preferably the handset is designed so that the speech source 1 (e.g. the user's mouth in the case of a radio telephone) is near one of the port openings (e.g. see figures 6 and 7). The port dimensions should be chosen bearing in mind the effects of their pressure transfer functions in the above equations. It is useful to have the port resonance frequencies above the frequency range of interest, so that the microphone's sensitivity does not rise too much at the top of the range.

The present invention extends to handsets comprising commercial noise cancelling electret condenser microphone capsules with separate ports to the front and back of its diaphragm, where the ports within the capsule are not completely symmetrical. Symmetricality is precluded by the basic design of some commercial electret condenser microphone capsules, with its backplate and integrated FET preamplifier.

Hence, the overall pressure transfer functions of the ports of such microphones are not equal, and the microphone is not a pure pressure-gradient microphone. Instead, its output is proportional to a combination of sound pressure and pressure gradient.

However, as can be seen from the above models, noise discrimination is further improved if the pressure transfer functions of the ports are equal, e.g. if the two port microphone is a pressure gradient microphone.

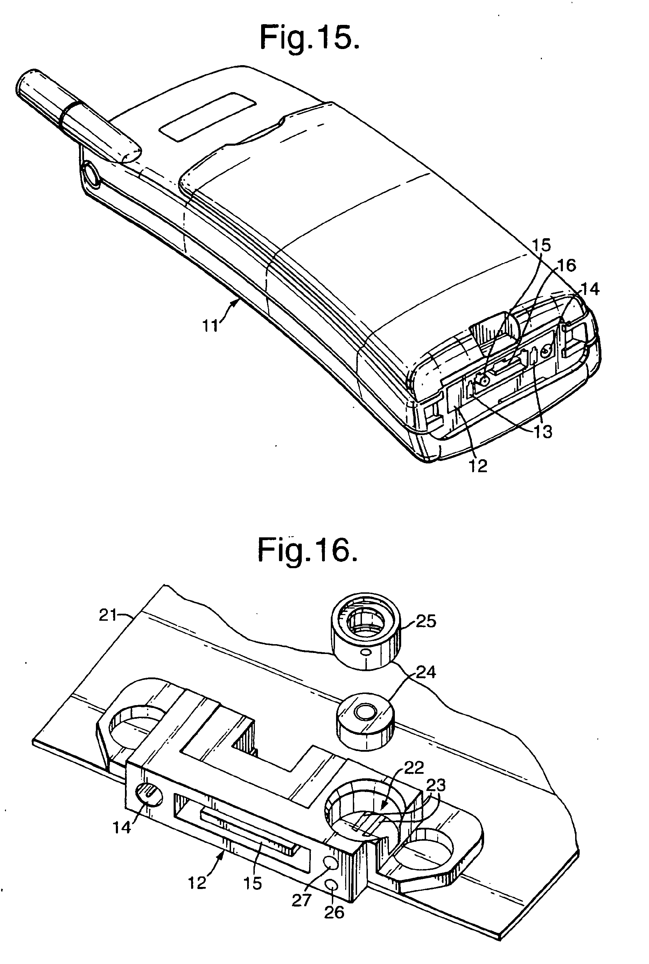

In a preferred embodiment of the present invention, the port openings are in a handset connector. Figures 15 to 17 show a radio telephone with such a connector. Referring to Figure 15 there is shown a connector 12 integrated into a handset in the form of a radio telephone 11. The connector 12 is exposed along one of its surfaces by an opening on the radio telephone housing to allow external electrical connections to be made with the connector 12. The connector 12 acts as a physical and electrical interface between the external connections and the circuitry of the radio telephone 11.

The connector 12 includes four external electrical connectors 13, 14, 15, and 16. The two connectors 13 and 14 both enable a power supply connection to be made to the radio telephone 11 to provide the radio telephone 11 with electrical power. This electrical power may be used to recharge the batteries of the radio telephone 11. Connector 13 comprises two electrically conductive elements which are designed to be placed on power pins of a charger stand. Connector 14 is a socket which comprises an electrically conductive centre pin and an outer electrically conductive surround and is designed to receive a plug of a charger unit. Connector 15 is an RF connector for supplying RF electrical signals to and/or from the radio telephone 11. The RF connector 15 enables an external RF connection such as an external booster antenna to be made to the radio telephone 11. Connector 16 is a data connector which has a multitude of electrically conductive elements that enable transfer of data in the form of electrical signals to and/or from the radio telephone 11.

Referring now to Figure 16 there is shown a connector 12, a circuit board 21, a microphone 24 and an elastomeric insulating boot 25. The connector 12 comprises a power supply connector 14, a data connector 15, ports 26 and 27, a microphone recess 22, and a pair of contacts 23 for the microphone.

The connectors 14 and 15 each have electrically conductive contacts which enable external electrical connections to be made. These contacts of the connectors 14 and 15 individually form part of electrically conductive tracks which pass through the plastic body of the system connector 12. An electrically conductive tab is provided at the end of each track to enable the track to be soldered to tracks on the surface of the circuit board. In this way the contacts of the connectors 14 and 15 may be individually coupled to the appropriate tracks on the circuit board 21.

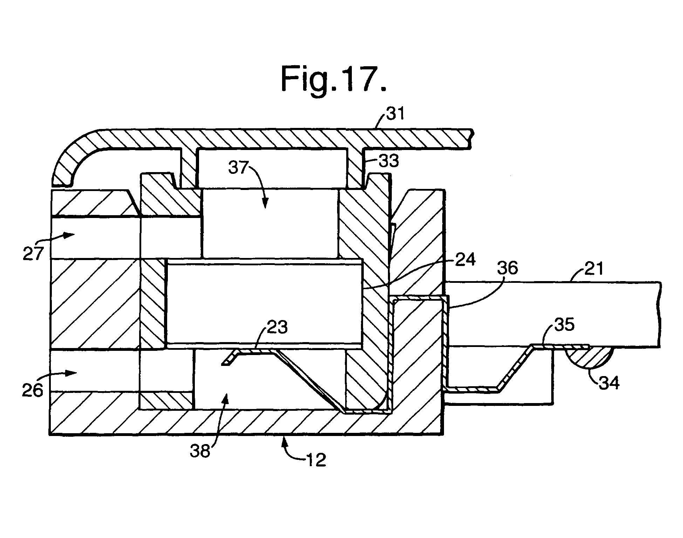

The connector 12 is provided with a recess 22 for receiving the microphone 24. Before inserting the microphone 24 into the connector 12, the microphone 24 is first placed inside the elastomeric boot 25. The elastomeric boot 25 containing the microphone 24 is then push fitted inside the recess 22 until a snug fit of the boot 25 in the recess 22 is achieved as shown in Figure 17. The elastomeric boot 25 serves to secure the microphone 24 into the recess 22 and to maintain the microphone 24 in the correct position within the recess 22. The elastomeric boot 25 also provides sound insulation for the microphone 24.

The microphone contacts 23 of the connector 12 automatically couple to the microphone 24 when the microphone 24 and boot 25 are push fitted into the recess. Concentric electrically conductive contacts are provided as output terminals of the microphone 24 to enable the microphone 24 to electrically contact with the contacts 23 irrespective of the rotational orientation of the microphone 24 in the recess 22. The contacts 23 are in the form of metal spring contacts which are biased towards the microphone output terminals to ensure that a good electrical contact is maintained. Each contact 23 forms part of an electrically conductive track 36 which passes through the connector 12 to an electrically conductive tab 35. The tabs 35 enable each track to be soldered 34 onto an appropriate microphone track on the surface of the circuit board.

The two microphone tracks 36 and the tracks of the connectors 14 and 15 when soldered to the circuit board provide a suitable mounting of the connector 12 to the circuit board 21. During assembly of the radio telephone 11, the connector 12 may be positioned on the circuit board 21 by a pick and place machine and then soldering of the microphone tracks 36 and the connector tracks 14 and 15 to the circuit board 21 may be performed using reflow soldering techniques.

A front cover 31 of the radio telephone 11 is placed over the connector 12, microphone 24, and boot 25, as shown in Figure 16. The presence of the front cover 31 and the cylindrical wall 33 assists in forming a cavity 37 above the microphone 24. A port 27 is provided as a hole in the body of the connector as shown in Figures 16 and 17. The port opens onto the exposed face of the connector 12 and emerges the other end in cavity 37. Hence it allows sound waves, typically from a voice, to enter the cavity 37 from the base of the telephone 11 and be received by the microphone 24. A sound proof gasket seal is formed by the cylindrical wall 33 acting against the elastomeric boot 25 preventing additional noise from entering the cavity 37 and being received by the microphone 24.

The front cover 31, the connector 12, and the boot 25 encapsulate the microphone 24 so that it is enclosed within the telephone 11.

In addition to the first port 27, a second port 26 is provided in the connector 12. As with the first port 27, the second port 26 is provided as a hole in the body of the system connector as shown in Figures 16 and 17. The opening of the port 26 is on the exposed face of the system connector 12. The port 26 continues through the system connector 12 and emerges in a second cavity 38. This cavity 38 is formed by the gap between the lower surface of the microphone 24 and the connector 12 which is caused by the lower flange of the elastomeric boot 25. This second port 26 allows sound waves incident on the exposed surface of the connector 12 to enter the second cavity 38. That is sound waves entering the second cavity 38 are received by the lower, noise cancelling surface of the microphone 24. Hence, the complete assembly therefore enables a noise cancelling microphone to operate using the two separate ports 26 and 27 without the need for any holes to be formed in the front or rear covers of the radio telephone 11.

Also, because the ports open at the same surface of the connector and the connector is disposed on the handset such that the openings of the ports and the expected location of the user's mouth are in substantial alignment, noise discrimination is optimised.

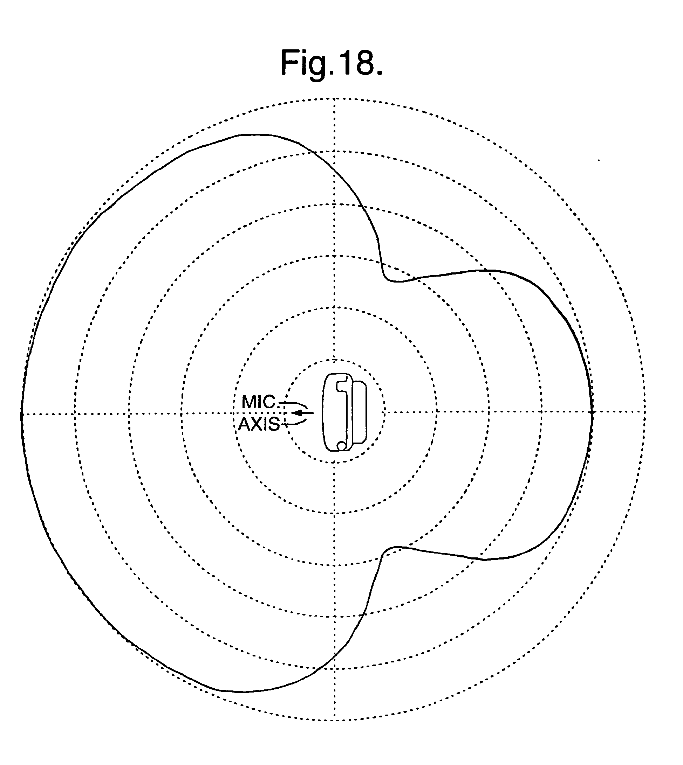

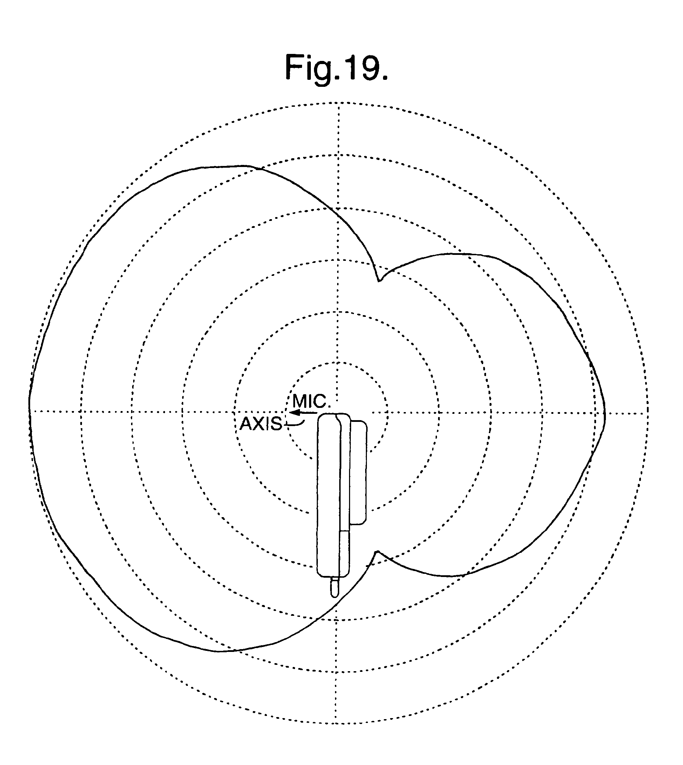

Figures 18 and 19 illustrate typical far field directivity for a first order microphone handset according to the present invention. Figure 18 shows the far field directivity in the base plane, and Figure 19 in the plane of symmetry.

In view of the foregoing description it will be evident to a person skilled in the art that various modifications may be made. For example, the spring contacts for the microphone connection need not necessarily be on the system connector but may instead be on output terminals of the microphone.

**Claims**

1. A handset (11) comprising a connector (12), the connector comprising:

   a connector body having an exterior face, the exterior face to be exposed out of an opening in the handset when the connector is mounted in the handset, the connector body further comprising:

   a microphone housing;
   first and second microphone ports (26, 27) each defining respective interior channels which extend from the exterior face of the connector body (12) to the associated microphone housing, the ports and microphone housing associated to allow audio input from the exterior face to a microphone provided in the microphone housing, and wherein the opening of one of the ports is closer to the first surface of the handset than the opening of the other port in order to provide directionality for a microphore located in the microphore housing.

2. The handset of claim 1, wherein the connector body further comprises a third microphone port defining a third interior channel which extends from the exterior face of the connector body (12) to the associated microphone housing, the three ports and microphone housing associated to allow audio input from the exterior face to a microphone provided in the microphone housing.

3. The handset of claim 1 or 2, wherein the microphone housing comprises a recess or formations projecting from the connector.

4. The handset of any preceding claim, wherein the exterior face of the connector body is configured to form part of the base of the handset when mounted in the handset

5. The handset of any preceding claim, wherein the microphone housing is configured to receive a microphone which is itself located in an elastomeric boot before being placed in the connector.

6. The handset of claim 5, wherein the elastomeric boot is configured to maintain the microphone in the correct position, with respect to the ports, within the microphone housing.

7. The handset of any preceding claim, wherein the microphone housing is configured to receive a pressure gradient microphone, and the microphone ports are configured for use with a pressure gradient microphone.

8. The handset of any preceding claim, wherein the connector is configured to act as a physical and electrical interface between external connections and circuitry of the handset, the external connections providing for one or more of a power supply connection, an RF connector, and a data connector.

9. The handset of any preceding claim, wherein the microphone housing is configured to receive a microphone comprising a differential array, and the microphone ports are configured for use with a differential array.

10. The handset of any preceding claim, wherein the connector is configured to be mounted on a circuit board of the handset (11), further comprising one or more conductive tracks (13-16) disposed such that an output terminal of the microphone (24) contacts the conductive track (13-16) for coupling the microphone (24) to the circuit board of the handset (11).

11. The handset of claim 10, wherein the one or more conductive tracks (13-16) are provided with a spring contact configured to contact an output terminal of the microphone (24).

12. The handset of any preceding claim, wherein the connector is configured to receive the microphone by push fitting the microphone (11).

**Patentansprüche**

1. Ein Handgerät (11), das ein Anschlussstück (12) umfasst, wobei das Anschlussstück umfasst:

   einen Anschlussstückkörper mit einer äußeren Fläche, wobei die äußere Fläche aus einer Öffnung des Handgerätes zu exponieren ist, wenn das Anschlussstück in dem Handgerät befestigt ist, wobei der Anschlussstückkörper ferner umfasst:

   ein Mikrofongehäuse:

   erste und zweite Mikrofoneinlässe (26, 27), von denen jeder jeweilige innere Kanäle festlegt, die sich von der Außenfläche des Anschlussstückkörpers (12) zu dem zugeordneten Mikrofongehäuse erstrecken, wobei die Einlässe und das Mikrofongehäuse zugeordnet sind, um Audioeingabe von der Außenfläche an ein Mikrofon zu ermöglichen, das in dem Mikrofongehäuse bereitgestellt ist, und wobei die Öffnung von einem der Einlässe näher an der Vorderseite des Handgerätes ist als die Öffnung des anderen Einlasses, um eine Richtungsabhängigkeit für ein Mikrofon in dem Mikrofongehäuse bereitzustellen.

2. Das Handgerät nach Anspruch 1, wobei der Anschlussstückkörper ferner einen dritten Mikrofoneinlass umfasst, der einen dritten inneren Kanal festlegt, der sich von der Außenfläche des Anschlussstückkörpers (12) zu dem zugeordneten Mikrofongehäuse erstreckt, wobei die drei Einlässe und das Mikrofongehäuse zugeordnet sind, um Audioeingabe von der Außenfläche an ein Mikrofon zu ermöglichen, das in dem Mikrofongehäuse bereitgestellt ist.

3. Das Handgerät nach Anspruch 1 oder 2, wobei das Mikrofongehäuse eine Ausnehmung oder Ausbildungen umfasst, die von dem Anschlussstück hervorragen.

4. Das Handgerät nach irgendeinem vorstehenden Anspruch, wobei die Außenfläche des Anschlussstückkörpers eingerichtet ist, einen Teil der Basis des Handgerätes zu bilden, wenn er in dem Handgerät befestigt ist.

5. Das Handgerät nach irgendeinem vorstehenden Anspruch, wobei das Mikrofongehäuse eingerichtet ist, ein Mikrofon aufzunehmen, das selbst in einer elastomeren Hülle angeordnet wird, bevor es in dem Anschlussstück angeordnet wird.

6. Das Handgerät nach Anspruch 5, wobei die elastomere Hülle eingerichtet ist, das Mikrofon in der korrekten Position bezüglich der Einlässe innerhalb des Mikrofongehäuses zu halten.

7. Das Handgerät nach irgendeinem vorstehenden Anspruch, wobei das Mikrofongehäuse eingerichtet ist, ein Druckgradientenmikrofon aufzunehmen, und die Mikrofoneinlässe zur Verwendung mit einem Druckgradientenmikrofon eingerichtet sind.

8. Das Handgerät nach irgendeinem vorstehenden Anspruch, wobei das Anschlussstück eingerichtet ist, als eine physikalische und elektrische Schnittstelle zwischen äußeren Verbindungen und Schaltkreisen des Handgerätes zu dienen, wobei die äußeren Verbindungen eine oder mehrere von einer Stromversorgungsverbindung, einem Funkfrequenzanschluss und einem Datcnanschluss bereitstellen.

9. Das Handgerät nach irgendeinem vorstehenden Anspruch, wobei das Mikrofongehäuse eingerichtet ist, ein Mikrofon aufzunehmen, das ein differentielles Array umfasst, und die Mikrofoneinlässe zur Verwendung mit einem differentiellen Array eingerichtet sind.

10. Das Handgerät nach irgendeinem vorstehenden Anspruch, wobei das Anschlussstück eingerichtet ist, auf einer Platine des Handgerätes (11) befestigt zu werden, die ferner eine oder mehrere leitende Bahnen (13-16) umfasst, die derart angeordnet sind, so dass ein Ausgangsanschluss des Mikrofons (24) die leitenden Bahnen (13-16) zum Koppeln des Mikrofons (24) an die Platine des Handgerätes (11) kontaktiert.

**11.** Das Handgerät nach Anspruch 10, wobei die eine oder mehreren leitenden Bahnen (13-16) mit einem Federkontakt bereitgestellt sind, der eingerichtet ist, um einen Ausgangsanschluss des Mikrofons (24) zu kontaktieren.

**12.** Das Handgerät nach irgendeinem vorstehenden Anspruch, wobei das Anschlussstück eingerichtet ist, das Mikrofon durch Steckverbinden des Mikrofons (11) aufzunehmen.

**Revendications**

**1.** Combiné portatif (11) comprenant un connecteur (12), le connecteur comprenant :

un corps de connecteur ayant une face extérieure, la face extérieure devant être exposée à travers une ouverture dans le combiné portatif lorsque le connecteur est monté dans le combiné portatif, le corps de connecteur comprenant en outre :

un boîtier de microphone ;
des premier et deuxième orifices de microphone (26, 27) définissant chacun des canaux intérieurs respectifs qui s'étendent de la face extérieure du corps de connecteur (12) jusqu'au boîtier de microphone associé, les orifices et le boîtier de microphone étant associés pour permettre l'entrée audio de la face extérieure vers un microphone fourni dans le boîtier de microphone, et dans lequel l'ouverture de l'un des orifices est plus proche de la surface avant du combiné portatif que l'ouverture de l'autre orifice pour assurer la directionnalité pour un microphone situé dans le boîtier de microphone.

**2.** Combiné portatif selon la revendication 1, dans lequel le corps de connecteur comprend en outre un troisième orifice de microphone définissant un troisième canal intérieur qui s'étend de la face extérieure du corps de connecteur (12) jusqu'au boîtier de microphone associé, les trois orifices et le boîtier de microphone étant associés pour permettre l'entrée audio de la face extérieure vers un microphone fourni dans le boîtier de microphone

**3.** Combiné portatif selon la revendication 1 ou 2, dans lequel le boîtier de microphone comprend un renfoncement ou des formations se projetant du connecteur.

**4.** Combiné portatif selon l'une quelconque des revendications précédentes, dans lequel la face extérieure du corps de connecteur est configurée pour faire partie de la base du combiné portatif lorsqu'elle est montée dans le combiné portatif.

**5.** Combiné portatif selon l'une quelconque des revendications précédentes, dans lequel le boîtier de microphone est configuré pour recevoir un microphone qui se trouve dans un sabot élastomère avant d'être placé dans le connecteur.

**6.** Combiné portatif selon la revendication 5, dans lequel le sabot élastomère est configuré pour maintenir le microphone à la position correcte, par rapport aux orifices, à l'intérieur du boîtier de microphone.

**7.** Combiné portatif selon l'une quelconque des revendications précédentes, dans lequel le boîtier de microphone est configuré pour recevoir un microphone à gradient de pression, et les orifices de microphone sont configurés pour une utilisation avec un microphone à gradient de pression.

**8.** Combiné portatif selon l'une quelconque des revendications précédentes, dans lequel le connecteur est configuré pour servir d'interface physique et électrique entre des connexions externes et un circuit du combiné portatif, les connexions externes assurant un ou plusieurs d'une connexion d'alimentation électrique, d'un connecteur RF et d'un connecteur de données.

**9.** Combiné portatif selon l'une quelconque des revendications précédentes, dans lequel le boîtier de microphone est configuré pour recevoir un microphone comprenant un réseau différentiel, et les orifices de microphone sont configurés pour une utilisation avec un réseau différentiel.

**10.** Combiné portatif selon l'une quelconque des revendications précédentes, dans lequel le connecteur est configuré pour être monté sur une carte de circuit du combiné portatif (11), comprenant en outre une ou plusieurs pistes conductrices (13-16) disposées de sorte qu'une borne de sortie du microphone (24) soit en contact avec la piste conductrice (13-16) pour coupler le microphone (24) à la carte de circuit du combiné portatif (11).

11. Combiné portatif selon la revendication 10, dans lequel la ou les pistes conductrices (13-16) sont munies d'un contact à ressort configuré pour être en contact avec une borne de sortie du microphone (24).

12. Combiné portatif selon l'une quelconque des revendications précédentes, dans lequel le connecteur est configuré pour recevoir le microphone en poussant le microphone (11) pour l'installer.

## Fig.1.

SOUND
SOURCE
1

ELECTROMECHANICAL
TRANSDUCER

DIAPHRAGM
4

5

PORT 3

MICROPHONE
CASING 2

PREAMPLIFIER

6

OUTPUT
VOLTAGE

## Fig.3.

MODEL

MEASURED

SPEECH LEVEL (dBrel)

DISTANCE IN FRONT OF LIPS (cm)

## Fig.4.

POINT
SOURCE

$r_2$

$r_1$

MIC
AXIS

$\theta$

PORT
OPENING 1

$\Delta x$

PORT
OPENING 2

# Fig.2(a).

# Fig.2(b).

# Fig.2(c).

25

# Fig.5.

# Fig.6.

# Fig.7.

# Fig.8.

1 cm FROM LIPS

# Fig.9.

## MAGNITUDE OF DIRECTIVITY
## (dB) VS. ANGLE OFF MICROPHONE AXIS (DEGREES)

K=0 (OMNIDIRECTIONAL)

K=1/2 (CARDIOID)

K=2/3 (HYPERCARDIOID)

K=1 (BIDIRECTIONAL)

# Fig.10.

# Fig.11.

# Fig.12.

# Fig.13.

MAGNITUDE OF DIRECTIVITY (dB) VS.
ANGLE OFF MICROPHONE AXIS (DEGREES)

# Fig.14.

HANDSET
CASING
8

2
HOUSING
BLOCK

7

LEADS TO
MICROPHONE
CAPSULE

4

SOUND FROM
USER'S MOUTH 1

32
FRONT
PORT

36
BACK
PORT

# Fig.15.

# Fig.16.

# Fig.17.

# Fig.18.

# Fig.19.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5303307 A